# EUROPÄISCHE PATENTSCHRIFT

(11) **EP 1 643 823 B1**
(45) Veröffentlichungstag und Bekanntmachung des Hinweises auf die Patenterteilung: **09.05.2007**
(21) Anmeldenummer: 05020941.0
(22) Anmeldetag: 26.09.2005
(51) Int. Cl.: H05K 7/20, H01L 23/46, G05D 23/08, G05D 23/13

(54) **Fluid-Kühleinrichtung zur Kühlung wenigstens einer Verlustwärme erzeugenden Komponente**
Fluid cooling device to cool at least one heat producing component
Dispositif de refroidissement pour refroidir au moins un composant qui produit de la chaleur

(30) Priorität: 27.09.2004 DE 102004046790
(43) Veröffentlichungstag der Anmeldung: 05.04.2006
(73) Patentinhaber: KERMI GmbH, 94447 Plattling (DE)
(72) Erfinder: Fonfara, Harald, 94551 Lalling (DE); Göstl, Herbert, 94227 Zwiesel (DE)
(74) Vertreter: Eder, Thomas

(56) Entgegenhaltungen:
- EP-A- 0 363 098
- DE-U1- 20 120 762
- GB-A- 946 275
- PATENT ABSTRACTS OF JAPAN Bd. 017, Nr. 517 (M-1481), 17. September 1993 (1993-09-17) & JP 05 133234 A (AISAN IND CO LTD), 28. Mai 1993 (1993-05-28)

## Beschreibung

Die Erfindung betrifft eine Fluid-Kühleinrichtung zur Kühlung von wenigstens einer Verlustwärme erzeugenden Komponente, insbesondere einem elektronischen Bauelement, wie einem Mikroprozessor, mit den Merkmalen des Oberbegriffs des Patentanspruchs 1.

Des Weiteren betrifft die Erfindung ein Regelventil für den Einsatz in Verbindung mit einer derartigen Fluid-Kühleinrichtung.

Zur Kühlung von elektronischen Bauelementen, wie hochgetakteten Mikroprozessoren, welche eine hohe Verlustleistung erzeugen, finden vornehmlich Fluid-Kühleinrichtungen, insbesondere Wasser-Kühleinrichtungen, Einsatz, da die Verlustwärme derartiger Komponenten unter Verwendung von luftgekühlten Kühlkörpern - sei es mit oder ohne Ventilator - nicht mehr in ausreichender Weise abgeführt werden kann, um die Temperatur der zu kühlenden Komponente unter einer maximal vorgegebenen Temperatur zu halten.

Bekannte Fluid-Kühleinrichtungen umfassen üblicherweise eine Pumpe zur Förderung des Kühlfluids, einen vom Kühlfluid durchflossenen Kühlkörper, welcher auf die zu kühlende Komponente aufgesetzt wird, wobei ein guter Wärmeübergang zwischen der zu kühlenden Komponente und dem Kühlkörper entstehen sollte, und einer Wärmesenke, beispielsweise in Form eines Wärmetauschers. Das Kühlmittel wird mittels der Pumpe aus der Wärmesenke, welche gleichzeitig das Kühlfluid-Reservoir mit beinhalten kann, über eine Fluidleitung zum Kühlkörper gefördert und von diesem wieder zurück in die Wärmesenke bzw. das Kühlfluid-Reservoir. Eine derartige Kühleinrichtung ist beispielsweise aus der DE 201 20 762 U1 bekannt, wobei die hier beschriebene Kühleinrichtung in spezieller Weise so ausgestaltet ist, dass die den Kühlkörper über Leitungen mit Kühlfluid versorgenden Bestandteile in einer adapterartig an das Gehäuse, in welchem die zu kühlende Komponente angeordnet ist, beispielsweise ein Computergehäuse, anschließbaren Einheit zusammengefasst sind.

In größeren EDV-Anlagen, beispielsweise in einem Server-Rack, sind eine Vielzahl von Geräten angeordnet, in welchen jeweils ein oder mehrere zu kühlende Komponenten, wie Mikroprozessoren, vorgesehen sind. Üblicherweise werden die in einem Gerät vorgesehenen, zu kühlenden Komponenten von ein und demselben Kühlfluid-Strom durchflossen und gekühlt. Der jeweils einzelne Kühlfluid-Strom muss selbstverständlich so bemessen sein, dass in jedem Fall eine ausreichende Kühlung sämtlicher, in Reihe geschalteter, zu kühlender Komponenten gewährleistet werden kann. Die Kühlfluid-Ströme der einzelnen Geräte sind üblicherweise parallel geschaltet, wobei mehrere oder alle Geräte von einem Kühlfluid-Gesamtstrom versorgt werden, der in die jeweils einzelnen, parallelen Kühlfluid-Teilströme aufgeteilt wird. Die Aufteilung erfolgt bei gleichartigen Geräten üblicherweise derart, dass die einzelnen Kühlfluid-Teilströme im Wesentlichen dieselbe Flussrate besitzen.

Nachteilig bei derart komplexen Kühleinrichtungen ist, dass der Kühlfluid-Gesamtstrom in jedem Fall eine Flussrate aufweisen muss, die gewährleistet, dass die Flussraten der einzelnen Kühlfluid-Teilströme ausreichen, um die maximal mögliche Verlustleistung ausreichend von den einzelnen zu kühlenden Komponenten abzuführen. Die Flussraten der Kühlfluid-Teilströme und damit die Flussrate des Kühlfluid-Gesamtstroms sind bei derartigen Kühleinrichtungen konstant.

Damit muss die Förderpumpe in jedem Fall so ausgelegt sein, dass im Dauerbetrieb die zur Erzeugung des (maximalen) Kühlfluid-Gesamtstroms notwendige Pumpleistung erbracht werden kann. Dies führt zu entsprechend großen und teuren Pumpen, die zudem im Dauerbetrieb üblicherweise mit der Nennleistung betrieben werden, wodurch ein hoher Energieverbrauch für die Pumpe entsteht. Dies gilt bei derartigen bekannten Kühleinrichtungen unabhängig davon, ob die zu kühlende Komponente eine zeitlich konstante, hohe Verlustleistung erzeugt, oder ob, wie dies häufig der Fall ist, die zu kühlende Komponente einen zeitlich nicht konstanten Verlauf der Verlustleistung aufweist.

Der Erfindung liegt daher die Aufgabe zu Grunde, eine Fluid-Kühleinrichtung zur Kühlung von wenigstens einer Verlustwärme erzeugenden Komponente, insbesondere einem elektronischen Bauelement, zu schaffen, welche einen reduzierten Energiebedarf für die das Kühlfluid fördernde Pumpe aufweist, wenn die Verlustleistung der zu kühlenden Komponente zeitlich nicht konstant ist, und welche auf einfache und kostengünstige Weise herstellbar ist.

Die Erfindung geht von der Erkenntnis aus, dass die mittlere Pumpenleistung und gegebenenfalls auch die Nennleistung der Pumpe geringer gewählt werden kann, wenn die Flussrate des Kühlfluid-Stroms, in welchem die wenigstens eine zu kühlende Komponente angeordnet ist, im Wesentlichen der momentanen Verlustleistung der wenigstens einen zu kühlenden Komponente angepasst wird. Hierzu wird erfindungsgemäß die Temperatur des Kühlfluids erfasst und die Flussrate des Fluidstroms abhängig von der Temperatur des Kühlfluids so geregelt oder gesteuert, dass die Temperatur des Kühlfluids eine vorgegebene Soll-Temperatur innerhalb vorgegebener Schranken einhält. Die Temperatur des Kühlfluids wird dabei an einem Punkt des Fluidstroms gemessen, der stromabwärts bezogen auf die wenigstens eine zu kühlende Komponente liegt. Sind mehrere zu kühlende Komponenten in Reihe von demselben Fluidstrom durchflossen, so wird die Temperatur an einem Punkt stromabwärts der letzten vom Fluidstrom durchflossenen zu kühlenden Komponente gemessen.

Hierdurch ergibt sich der Vorteil, dass insbesondere bei zu kühlenden Komponenten, die nur kurzzeitig Spitzenwerte der Verlustleistung erzeugen, Pumpen eingesetzt werden können, die eine Nennleistung aufweisen, die kleiner ist als die Pumpenleistung, die für das Erzeugen der maximalen Flussrate für das Abfördern der maximalen Verlustleistung erforderlich wäre. Da unter den genannten Voraussetzungen die Verlustleistung den Maximalwert nur jeweils für eine kurze Zeit erreicht, kann die Pumpe für diese kurzen Zeiträume mit einer höheren Leistung als die jeweilige Nennleistung betrieben werden.

In den Zeiträumen, in denen nur eine geringe Verlustleistung erzeugt wird, wird der Kühlmittelstrom durch das Ventil soweit reduziert, dass die Pumpe zur Förderung des Kühlmittels nur mit geringer Leistung laufen muss.

Der vorgenannte Vorteil ergibt sich beispielsweise beim Einsatz von Pumpen zur Förderung des Kühlfluids, welche einen konstanten Druck für das zu fördernde Kühlfluid am Pumpenausgang oder eine konstante Druckdifferenz zwischen dem Vorlauf- und Rücklaufanschluss der Pumpe erzeugen. Denn bei derartigen Pumpen wird die Pumpenleistung automatisch reduziert bzw. heruntergeregelt, wenn die notwendige Flussrate bei gleichem Förderdruck bzw. gleicher Druckdifferenz zwischen Vor- und Rücklauf reduziert werden kann. Die gesamte Regelvorrichtung nach der Erfindung umfasst somit das steuerbare Ventil und Mittel zur Erfassung der Temperatur des Kühlfluids an einem geeigneten Punkt im Verlauf des Fluidstroms. Beispielsweise kann die erfasste Temperatur einer Auswerte- und Steuereinheit der Regelvorrichtung zugeführt werden, die das steuerbare Ventil in geeigneter Weise ansteuert.

Nach einer Ausführungsform der Erfindung kann die Regelvorrichtung als Regelventil ausgebildet sein, welches vorzugsweise die Temperatur des Kühlfluids am Ort des Regelventils in der Fluidleitung misst. Hierdurch ergibt sich eine sehr einfache und kostengünstige Bauweise für die Regelvorrichtung. Das Regelventil kann dabei insbesondere als passives Thermostatventil ausgebildet sein.

Nach der bevorzugten Ausführungsform weist das steuerbare Ventil bzw. das Regelventil eine "Geschlossen-Stellung" auf, in welcher der Fluidstrom nicht vollständig unterbrochen ist, sondern eine vorbestimmte Leck-Flussrate aufweist. Auf diese Weise kann verhindert werden, dass eine Überhitzung der zu kühlenden Komponenten dadurch auftritt, dass das steuerbare Ventil oder das Regelventil den Kühlfluid-Strom in einer Phase, in der keinerlei Verlustleistung abzuführen ist, vollständig unterbricht und in einer anschließenden Phase, in welcher wieder eine bestimmte Verlustleistung erzeugt wird, das in der Fluidleitung zwischen der zu kühlenden Komponente und dem Messpunkt für die Fluid-Temperatur befindliche Kühlfluid am Ort des Messpunkts so langsam erwärmt und damit die Flussrate des Kühlfluids durch das Öffnen des Ventils zeitlich so lange verzögert wird, dass hierdurch die zu kühlende Komponente überhitzt bzw. vollkommen zerstört wird.

Die Leck-Flussrate ist dabei vorzugsweise unter Berücksichtigung des Kühlfluidvolumens in der Fluidleitung zwischen der mindestens einen zu kühlenden Komponente und der Reaktionszeit der Regelvorrichtung so zu wählen, dass bei einer plötzlichen Steigerung der Verlustleistung der mindestens einen Komponente der Fluidstrom innerhalb einer ausreichend kurzen Zeitspanne (gerechnet ab dem Zeitpunkt der plötzlichen Steigerung der Verlustleistung) so weit gesteigert wird, dass die mindestens eine Komponente nicht geschädigt oder zerstört wird.

Dieses Verfahren lässt sich selbstverständlich auch dann anwenden, wenn, wie vorstehend bereits ausgeführt, mehrere zu kühlende Komponenten in Reihe hinsichtlich der Flussrichtung des Kühlfluids geschaltet und von demselben Kühlfluid-Strom durchflossen sind. Der Punkt zur Erfassung der Temperatur ist dann stromabwärts bezogen auf die letzte der in Reihe geschalteten zu kühlenden Komponenten zu wählen.

Der Kühlfluid-Gesamtstrom kann auch auf mehrere parallele Zweige in einzelne Kühlfluid-Teilströme aufgeteilt werden, wobei in jedem Zweig mindestens eine Verlustwärme erzeugende Komponente angeordnet ist. Bei einer derartigen Anordnung ist erfindungsgemäß stromabwärts nach der mindestens einen Komponente bzw. stromabwärts nach der letzten mehrerer, in Reihe geschalteter Komponenten ein steuerbares Ventil oder ein Regelventil angeordnet.

Ein Regelventil nach der Erfindung, welches zur Realisierung der erfindungsgemäßen Fluid-Kühleinrichtung einsetzbar ist, kann ein Thermostatelement aufweisen, welches in thermischem Kontakt mit dem das Regelventil durchströmenden Medium steht und einen Ventilkörper beaufschlagt, wobei hierdurch der Ventilkörper, abhängig von der Temperatur des Mediums, zwischen einer "Geschlossen-Stellung", in welcher der Ventilkörper vorzugsweise zumindest mit einem Teilbereich an einem Ventilsitz anliegt und in welcher eine Leck-Flussrate ermöglicht ist, und einer "Offen-Stellung", in welcher der Ventilkörper vorzugsweise an einem die "Offen-Stellung" definierenden Anschlag anliegt, bewegt wird.

Der Ventilkörper kann dabei an der der Beaufschlagungsseite durch das Thermostatelement gegenüberliegenden Seite mittels einer Rückstellfeder, beispielsweise einer Schrauben-Druckfeder, druckbeaufschlagt sein.

Das Regelventil kann ein hülsenartig ausgebildetes Ventilgehäuse aufweisen, in welchem das Thermostatelement, der Ventilsitz und der Ventilkörper und die Rückstellfeder angeordnet sind, wobei das Ventilgehäuse an seinen gegenüberliegenden Enden Anschlüsse für Leitungen aufweist, mittels welcher dem Regelventil das dieses durchfließende Medium zuführbar und abführbar ist.

Weitere Ausführungsformen der Erfindung ergeben sich aus den Unteransprüchen. Die Erfindung wird nachfolgend anhand eines in der Zeichnung dargestellten Ausführungsbeispiels näher erläutert. In der Zeichnung zeigen:
- Fig. 1: ein schematisches Flussdiagramm einer Kühleinrichtung mit mehreren parallelen Zweigen, in welchen jeweils ein oder mehrere Verlustwärme erzeugende Komponenten angeordnet sind;
- Fig. 2: einen Längsschnitt durch ein Regelventil nach der Erfindung für den Einsatz in der Fluid-Kühleinrichtung nach Fig. 1 in seiner "Geschlossen-Stellung" und
- Fig. 3: einen Längsschnitt durch das Ventil in Fig. 1 in seiner "Offen-Stellung".

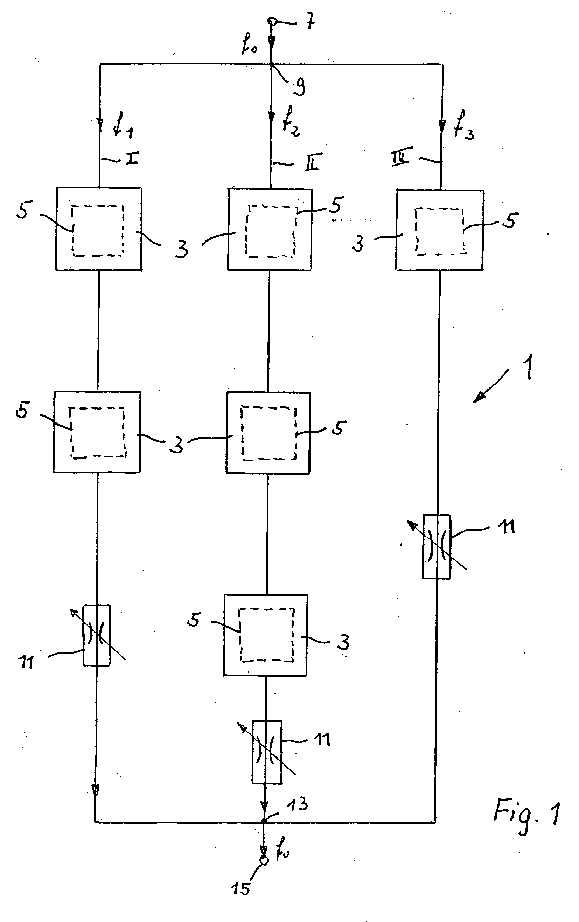

Die in Fig. 1 schematisch dargestellte Kühleinrichtung 1 umfasst mehrere vom Kühlfluid durchströmte Kühlkörper 3, die auf jeweils eine zu kühlende, Verlustwärme erzeugende Komponente 5 aufgesetzt sind, wobei jeweils zwischen dem Kühlkörper 3 und der zu kühlenden Komponente 5 ein Wärmeübergang mit geringem Wärmeübergangswiderstand ausgebildet ist. Das Kühlfluid wird dem in Fig. 1 dargestellten, für die Erfindung relevanten Teil der Kühleinrichtung 1 mittels einer nicht näher dargestellten Pumpe zugeführt. die Pumpe kann dabei so ausgebildet sein, dass diese am Zufluss 7 einen Kühlfluid-Gesamtstrom f₀ erzeugt, wobei die Druckdifferenz Δp₀ für das Kühlfluid zwischen dem Zufluss 7 und dem Abfluss 15 mittels der Pumpe (beispielsweise durch eine geeignete Regelung) konstant gehalten wird.

Der Kühlfluid-Gesamtstrom f₀ teilt sich an einem Verzweigungspunkt 9 in entsprechende Kühlfluid-Teilströme f₁, f₂ und f₃ in einen ersten, zweiten und dritten Teilzweig I, II, III auf.

Im Teilzweig I durchströmt der Kühlfluid-Teilstrom f₁ zwei in Reihe geschaltete Kühlkörper 3, welche die Verlustwärme von den zugehörigen Komponenten 5 abführen, und in Strömungsrichtung nach den beiden Kühlkörpern 3 ein Regelventil 11. Nach dem Regelventil 11 gelangt das Kühlfluid zum Zusammenführpunkt 13, an dem sich die Kühlfluid-Teilströme f₁, f₂ und f₃ wieder zum Kühlfluid-Gesamtstrom f₀ vereinigen und von diesem zum Abfluss 15. Selbstverständlich ist das Kühlfluid jeweils in entsprechenden Fluidleitungen geführt.

Der Verzweigungspunkt 9 und der Zusammenführpunkt 13 können durch sternförmig ausgebildete Verzweigungselemente gebildet sein. Diese können vorzugsweise so ausgestaltet sein, dass der Kühlfluid-Gesamtstrom unter der Voraussetzung von gleichen Strömungswiderständen in den einzelnen Teilzweigen in jeweils gleich große Kühlfluid-Teilströme f₁, f₂ und f₃ aufgeteilt werden.

Da die Kühlfluid-durchströmten Kühlkörper 3 jedoch einen endlichen Strömungswiderstand darstellen - wie auch die jeweils zwischen dem Zufluss 7, dem Verzweigungspunkt 9, den Kühlkörpern 3, dem Zusammenführpunkt 13 und dem Abfluss 15 befindlichen Fluidleitungen bzw. Fluidleitungsstücke - ergibt sich bei einer Konfiguration einer erfindungsgemäßen Kühleinrichtung wie in Fig. 1 eine jeweils unterschiedliche Flussrate für die Kühlfluid-Teilströme f₁, f₂, f₃. Denn der zweite Zweig II und der dritte Zweig III weisen drei bzw. lediglich einen einzigen Kühlkörper 3 auf.

Darüber hinaus kann auch jedes der in den Zweigen I, II, III angeordneten Regelventile 11 auch in seiner "Offen-Stellung" noch einen endlichen Strömungswiderstand aufweisen.

Jedes der Regelventile 11 misst, vorzugsweise an dem Ort, an dem das Regelventil 11 in der Fluidleitung zwischen dem in Strömungsrichtung letzten Kühlkörper 3 und dem Zusammenführpunkt 13 angeordnet ist, die Temperatur des Kühlfluids. Jedes Regelventil ist dabei so ausgebildet, dass es innerhalb seiner vorgegebenen Maximalstellungen, nämlich der "Geschlossen-Stellung" und der "Offen-Stellung", die Flussrate des jeweiligen Kühlfluid-Teilstroms f₁, f₂, f₃ jeweils so wählt, dass die gemessene Ist-Temperatur innerhalb eines vorgegebenen Bereichs um eine vorgegebene Soll-Temperatur liegt.

Der Kühlfluid-Gesamtstrom f₀, die Strömungswiderstände der Kühlkörper 3 und der Strömungswiderstand jedes der Regelventile 11 müssen dabei selbstverständlich so dimensioniert werden, dass sich in jedem Zweig eine ausreichende Kühlwirkung für den Fall ergibt, dass die zu kühlenden Komponenten 3 ihre maximale Verlustleistung erzeugen. In diesem Fall muss in der "Offen-Stellung" des Regelventils 11 jeweils ein ausreichender Kühlfluid-Teilstrom f₁, f₂, f₃ erzeugbar sein.

Dies ist selbstverständlich auch zu beachten, wenn in einem bereits vorhandenen Zweig I, II, III ein zusätzlicher Kühlkörper in Reihe mit den bereits vorhandenen Kühlkörpern geschaltet wird.

Durch das Vorsehen eines Regelventils 11 in jedem der Zweige I, II, III ergibt sich der Vorteil, dass die Flussrate dieser Kühlfluid-Teilströme jeweils an die im jeweiligen Zweig I, II, III erzeugte Gesamt-Verlustleistung angepasst werden kann. Ändert sich beispielsweise im Zweig III die von der Komponente 5 erzeugte Verlustleistung sprunghaft auf einen höheren Wert, so wird nach einer gewissen Verzögerungszeit das Regelventil 11 eine höhere Temperatur des Kühlfluids des Kühlfluid-Teilstroms f₃ feststellen und demzufolge das Ventil weiter öffnen. Durch die höhere Flussrate des Teilstroms f₃ ergibt sich dann eine verbesserte Kühlwirkung für die Komponente 5 im Zweig III. Verringert sich die Verlustleistung der Komponente 5 ab einem gewissen Zeitpunkt, so erfolgt nach einer gewissen Verzögerungszeit eine Reduzierung der Flussrate des Kühlfluid-Teilstroms f₃ im Zweig III durch das Regelventil 11. Die Verzögerungszeit hängt dabei ab von der Zeitspanne, die zwischen dem Zeitpunkt der Änderung der Verlustleistung der Komponente 5 und dem Zeitpunkt vergeht, zu dem diese Änderung der Verlustleistung infolge einer erhöhten Temperatur des Kühlfluids des Teilstroms f₃ am Ort des Regelventils 11 messbar ist.

Demzufolge empfiehlt es sich, das Regelventil 11 möglichst unmittelbar nach dem (jeweils letzten) Kühlkörper vorzusehen.

Der vorbeschriebene Vorteil ergibt sich bereits dann, wenn die Kühleinrichtung lediglich einen einzelnen Teilstrom mit einem einzigen Kühlkörper bzw. einer einzigen zu kühlenden Komponente 5 beinhaltet.

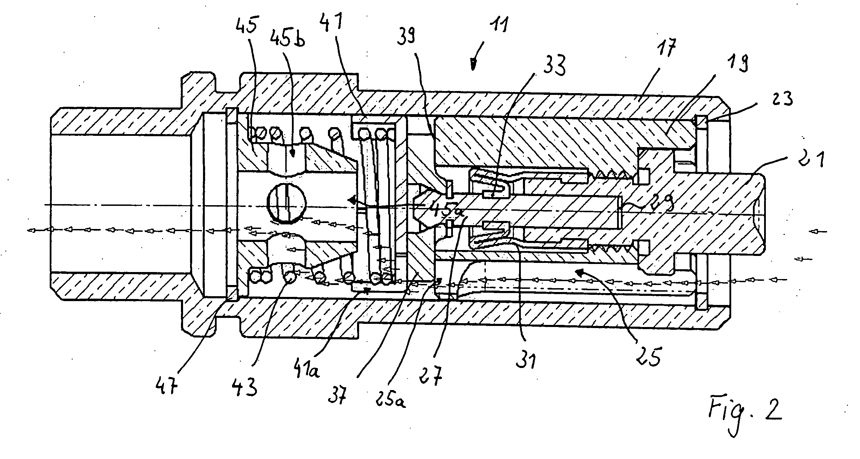

Befinden sich mehrere in Reihe geschaltete Kühlkörper 3 in einem Zweig, wie dies in Fig. 2 für die Zweige I und II der Fall ist, so hängt die Temperatur des Kühlfluid-Teilstroms f₁, f₂ jeweils von der gesamten Verlustleistung ab, die von den zwei Komponenten 5 (Teilzweig I) bzw. den drei Komponenten 5 (Teilzweig II) erzeugt werden.

Darüber hinaus wird im Fall einer Kühleinrichtung mit mehreren parallel geschalteten Zweigen der Vorteil erreicht, dass jeweils derjenige Zweig I, II, III eine höhere Flussrate führen kann, in dem die momentan jeweils höhere Verlustleistung abzuführen ist.

Die höhere Verlustleistung kann entweder dadurch erzeugt werden, dass in dem betreffenden Zweig eine größere Anzahl von in Reihe geschalteten Kühlkörpern 3 vorgesehen ist oder dass die eine oder mehreren Komponenten in dem betreffenden Zweig I, II, III eine momentan höhere Verlustleistung erzeugen. Handelt es sich bei den Komponenten 5 beispielsweise um Mikroprozessoren, so kann der Mikroprozessor in einem Sleep-Mode nur eine sehr geringe Verlustleistung erzeugen und unter Vollast eine vielfach höhere Verlustleistung.

Bei einer Aufteilung des Kühlfluid-Gesamtstroms f₀ in mehrere Kühlfluid-Teilströme kann durch das erfindungsgemäße Vorsehen von jeweils einem Regelventil 11 in einem Teilzweig die Aufteilung der Flussraten der Teilströme f₁, f₂, f₃ jeweils so erfolgen, dass die größte Flussrate tatsächlich in dem Zweig entsteht, in dem momentan die höchste Verlustleistung abzuführen ist.

Werden eine Vielzahl von Kühlfluid-Teilströmen durch ein Splitten des Kühlfluid-Gesamtstroms f₀ erzeugt, und kann angenommen werden, dass die zu kühlenden Komponenten 5 in den einzelnen Teilzweigen im zeitlichen Mittel eine in etwa konstante Gesamt-Verlustleistung erzeugen, kann die Flussrate des Kühlfluid-Gesamtstroms f₀ bzw. die Pumpe zur Erzeugung dieser Flussrate so dimensioniert werden, dass diese Flussrate gleich der für das Abführen der zeitlich konstanten Gesamt-Verlustleistung ist.

Es kann bei der Fluid-Kühleinrichtung nach der Erfindung auch in beliebiger Weise ein weiterer, paralleler Zweig, beispielsweise für eine oder mehrere in Reihe geschaltete Komponenten 5 hinzugefügt oder abgetrennt werden, ohne dass die übrigen Kühlfluid-Teilströme und damit die Kühlung der betreffenden Komponenten 5 beeinflusst werden. Durch die Regelventile 11 wird automatisch der erforderliche Massenstrom des Kühlfluids in jedem der parallelen Teilzweige eingestellt.

Es kann selbstverständlich auch ein Austausch einer Komponente 5 gegen eine andere Komponente 5 vorgenommen werden, die eine größere oder kleinere Verlustleistung benötigt. Auch in diesem Fall erfolgt selbsttätig eine Anpassung des erforderlichen Massenstroms des Kühlfluids.

Darüber hinaus kann auch eine Pumpe verwendet werden, die keinerlei Regelung aufweist, die jedoch so ausgebildet ist, dass sie (innerhalb einer vorbestimmten Grenze für den maximalen Massenstrom des Kühlfluids, d.h. für alle zulässigen Werte des Massenstroms innerhalb eines vorgegebenen Betriebsbereichs) sicher eine ausreichende Druckdifferenz Δp₀ des Drucks des Kühlfluids zwischen dem Zulauf 7 und dem Ablauf 15 sicherstellt. Schwankungen der Druckdifferenz werden dann ebenfalls durch die Regelventile 11 ausgeregelt und in jedem Fall eine ausreichende Kühlung der betreffenden Komponenten 5 sichergestellt. Es können somit auch einfache und damit preiswerte Pumpen verwendet werden. Geregelte Pumpen, die eine konstante Druckdifferenz Δp₀ liefern, bieten jedoch selbstverständlich den Vorteil, dass jeweils nur eine vorbestimmte konstante Druckdifferenz Δp₀ mit der jeweils hierzu erforderlichen Pumpenleistung erzeugt werden muss. Die tatsächliche (mittlere) Pumpenleistung wird daher geringer sein als bei einer nicht geregelten Pumpe, da bei letzterer die Pumpenleistung in jedem Fall von vornherein so groß gewählt werden muss, dass ein vorgegebener maximaler Gesamtstrom für das Kühlfluid (bei maximaler Gesamt-Kühlleistung) gefördert werden kann.

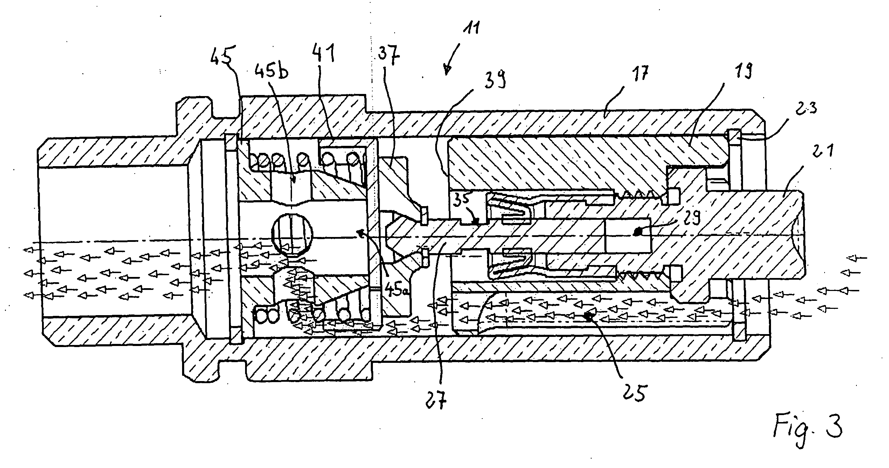

In den Fig. 2 und 3 ist ein Regelventil 11 dargestellt, welches sich zur Realisierung einer Kühleinrichtung nach Fig. 1 eignet.

Das jeweils im Längsschnitt dargestellte Regelventil 11 umfasst ein Ventilgehäuse 17 mit einer im Wesentlichen hohlzylindrischen Gestalt. Im in Fig. 3 rechts dargestellten Bereich ist im Inneren des Ventilgehäuses 17 ein Aufnahmeelement 19 für ein darin koaxial aufgenommenes Thermostatelement 21 gehalten. Das Thermostatelement 21 kann dabei mittels eines im Aufnahmeelement 19 vorgesehenen Innengewindes, welches mit einem am Außenumfang des Thermostatelements 21 vorgesehenen Außengewindes zusammenwirkt, fixiert sein. Das Fixieren des Aufnahmeelements 19 in axialer Richtung erfolgt mittels eines Fixierrings 23, welcher das in Fig. 3 rechte Ende des Aufnahmeelements 19 an seiner Stirnseite beaufschlagt. Das Aufnahmeelement weist an seinem Außenumfang wenigstens eine Längsnut 25 auf, durch welche das Kühlfluid, dessen Strömungsverlauf in den Fig. 2 und 3 mittels der Pfeile dargestellt ist, hindurchtritt. Beispielsweise kann das Aufnahmeelement 19 an seinem Außenumfang drei Längsnuten 25 aufweisen, die jeweils einen Winkel von 120° einschließen.

Das Thermostatelement 21 umfasst einen axial längsverschieblichen Kolben 27, der an seinem rückwärtigen Ende von einem flüssigen Medium 29 beaufschlagt ist, welches in einer Kammer aufgenommen ist, die von der Aufnahmeausnehmung des Thermostatelements 21 für den Kolben 27 und durch das rückwärtige Ende des Kolbens 27 gebildet ist. In seiner in Fig. 2 dargestellten "Geschlossen-Stellung" ist der Kolben 27 mittels eines federnden Eingreifelements 31, welches koaxial auf dem Außenumfang des Thermostatelements 21 gehalten ist, fixiert. Das Fixieren erfolgt mittels eines ringförmig ausgebildeten Bereichs 33 des federnden Eingreifelements 31, welcher in eine umlaufende Nut 35 im Außenumfang des Kolbens 27 eingreift. In seiner "Geschlossen-Stellung" liegt ein Ventilkörper 37, welcher im Wesentlichen dicht am vorderen Ende des Kolbens 27 gehalten ist, mit seiner stirnseitigen Umfangsfläche am Ventilsitz 39 an, der durch die vordere Stirnseite des Aufnahmeelements 19 gebildet wird. Hierdurch wird die stirnseitige Öffnung der Längsnuten 25 im Außenumfang des Aufnahmeelements 19 jeweils bis auf eine verbleibende Rest-Querschnittsfläche abgedichtet. Diese Rest-Querschnittsfläche definiert die Leck-Flussrate des Regelventils 11 in seiner "Geschlossen-Stellung". Der Ventilkörper 37 kann, wie in Fig. 2 dargestellt, im Wesentlichen scheibenartig ausgebildet sein, wobei sein Außendurchmesser so gewählt ist, dass sich der vorbestimmte Rest-Querschnitt der stirnseitigen Öffnung 25a der Längsnuten 25 ergibt, welche sich in radialer Richtung bis an den Außenumfang des Aufnahmeelements 19 erstrecken, welches einen größeren Durchmesser aufweist als der Ventilkörper 37.

Mit seiner vorderen Stirnseite beaufschlagt der Ventilkörper 37 ein topfförmiges Element 41, in welchem sich das eine Ende einer Schraubenfeder 43 abstützt. Das topfförmige Element 41 weist ebenfalls einen Außendurchmesser auf, der dem Innendurchmesser des Ventilgehäuses 17 entspricht. Die Schraubenfeder stützt sich mit ihrem anderen Ende auf einem hohlzylinderförmigen Anschlagselement 45 ab, das in axialer Richtung durch einen Fixierring 47 im Inneren des Ventilgehäuses 17 gehalten ist.

Das topfförmige Element 41 weist entsprechend der Anzahl der Längsnuten 25 im Aufnahmeelement 19 eine Anzahl von Einschnitten 41a in seiner Seitenwandung auf, durch welche das Kühlmedium strömen kann. In der in Fig. 2 dargestellten "Geschlossen-Stellung" des Regelventils 11 fließt das Kühlmedium von der in Fig. 2 rechts dargestellten Zuführseite durch die Längsnuten 25 über den Rest-Querschnitt der stirnseitigen Öffnungen 25a und die Einschnitte 41a im topfförmigen Element 41 durch die stimseitige Öffnung 45a des hohlzylindrischen Anschlagselements 45 sowie durch dessen seitliche, radial verlaufende Bohrungen 45b zur in Fig.2 links dargestellten Abflussseite des Regelventils 11. Zwischen dem Kühlmedium und dem Aufnahmeelement 19 bzw. dem darin gehaltenen Thermostatelement 21 besteht ein geringer Wärmeübergangswiderstand, wobei die Materialien dieser Elemente entsprechend gewählt sind. Erhöht sich die Temperatur des Kühlfluids, so dehnt sich das flüssige Medium 29 im Thermostatelement 21 aus, so dass sich der Kolben 27 in der Darstellung gemäß den Fig. 2 und 3 nach links bewegt. Hierdurch hebt der Ventilkörper 37 vom Ventilsitz 39 ab, so dass sich die Flussrate des Kühlfluids mit zunehmender Temperatur des Kühlfluids erhöht. Ist die Temperatur des Kühlfluids geringer als ein vorbestimmter Schwellwert, so bleibt das Regelventil 11 in seiner "Geschlossen-Stellung". In einem Bereich zwischen diesem unteren Schwellwert und einem oberen Schwellwert für die Temperatur hängt der Strömungswiderstand des Ventils und damit die Flussrate des Kühlfluids von der Temperatur des Kühlfluids ab. Ab einem gewissen oberen Schwellwert der Temperatur schlägt das topfförmige Element 41 an der Stirnseite des Anschlagselements 45 an, so dass ab diesem Schwellwert der Temperatur der Strömungswiderstand des Regelventils 11 und damit die Flussrate des Kühlfluids konstant bleibt. Innerhalb des Temperaturbereichs zwischen dem unteren und oberen Schwellwert erfolgt eine Regelung der Flussrate des Kühlfluids derart, dass eine vorgegebene Solltemperatur innerhalb ausreichend enger, gegebenenfalls vorgebbarer Grenzen eingehalten wird.

Das Regelventil gemäß den Fig. 2 und 3 weist den Vorteil auf, dass selbst für den Fall einer Verstopfung des Rest-Querschnitts der stirnseitigen Öffnung 25a einer der Längsnuten 25 durch kleine Verunreinigungen im Kühlfluid kaum gravierende Störungen zu erwarten sind. Denn in diesem Fall erhöht sich der Strömungswiderstand des Regelventils, so dass sich die Temperatur des Kühlfluids erhöht und demzufolge das Regelventil weiter öffnet. Selbst für den Extremfall, dass sämtliche Rest-Querschnitte aller Längsnuten 25 in der "Geschlossen-Stellung" des Regelventils verstopft sein sollten, erhöht sich die Temperatur des Kühlfluids - wenn auch langsamer als durch das Vorsehen der vorbestimmten Leck-Flussrate erwünscht - so weit, bis das Regelventil schließlich so weit öffnet, dass die Verunreinigungen aus dem Regelventil ausgespült werden.

Werden jedoch mehrere Längsnuten 25 vorgesehen, so ist die Wahrscheinlichkeit einer gleichzeitigen Verstopfung der Rest-Querschnittsflächen der stirnseitigen Öffnungen 25a in der "Geschlossen-Stellung" äußerst gering.

Dieses Ventil eignet sich somit zu einer einfachen und kostengünstigen Realisierung einer Kühleinrichtung nach der Erfindung, beispielsweise der Ausführungsform in Fig. 1.

Durch das Vorsehen einer Leck-Flussrate des Kühlfluids in der "Geschlossen-Stellung" wird ein sicherer Start der Kühleinrichtung nach einer Betriebspause gewährleistet. Da das Regelventil nach den Fig. 2 und 3 eine passive Regelung ohne eine erforderliche Hilfsenergie ermöglicht, wird eine hervorragende Zuverlässigkeit bei der Regelung des betreffenden Kühlfluid-Teilstroms erreicht.

Bei einer Parallelschaltung mehrerer Zweige von Kühlfluid-Teilströmen, wie dies in Fig. 1 dargestellt ist, kann ein dynamischer Abgleich der Kühlleistungen in den einzelnen Zweigen bei Schwankungen der Verlustleistung der zu kühlenden Komponenten 5 erreicht werden.

Bei späteren Erweiterungen der Kühleinrichtung um weitere Kühlkörper bzw. um weitere zu kühlende Komponenten muss auf den zusätzlichen hydraulischen Widerstand des zusätzlichen Kühlkörpers nicht geachtet werden. Der Abgleich erfolgt über das jeweilige Regelventil 11.

## Patentansprüche

1. Fluid-Kühleinrichtung zur Kühlung von wenigstens einer Verlustwärme erzeugenden Komponente, insbesondere einem elektronischen Bauelement,
a) bei der die von der wenigstens einen Komponente (5) erzeugte Verlustwärme auf ein der wenigstens einen Komponente mittels einer Fluidleitung zugeführtes Kühlfluid übertragen wird, und
b) bei der das Kühlfluid in einer Fluidleitung abgeführt wird,
**dadurch gekennzeichnet,**
c) **dass** eine Regelvorrichtung vorgesehen ist, welche ein in der das Kühlfluid abführenden Fluidleitung angeordnetes steuerbares Ventil (11) umfasst, mit welchem die Flussrate des Fluidstroms (f₁, f₂, f₃) des Kühlfluids abhängig von der Temperatur des Kühlfluids in der das Kühlfluid abführenden Fluidleitung so geregelt wird, dass die Temperatur des Kühlfluids eine vorgegebene Soll-Temperatur innerhalb vorgegebener Schranken einhält.

2. Fluid-Kühleinrichtung nach Anspruch 1, **dadurch gekennzeichnet, dass** die Regelvorrichtung als Regelventil (11) ausgebildet ist, welches vorzugsweise die Temperatur des Kühlfluids am Ort des Regelventils in der Fluidleitung misst.

3. Fluid-Kühleinrichtung nach Anspruch 2, **dadurch gekennzeichnet, dass** das Regelventil (11) ein passives Thermostatventil ist.

4. Fluid-Kühleinrichtung nach einem der vorhergehenden Ansprüche, **dadurch gekennzeichnet, dass** das steuerbare Ventil oder das Regelventil (11) eine "Geschlossen-Stellung" aufweisen, in welcher der Fluidstrom (f₁, f₂, f₃) nicht vollständig unterbrochen ist, sondern eine vorbestimmte Leck-Flussrate aufweist.

5. Fluid-Kühleinrichtung nach einem der vorhergehenden Ansprüche, **dadurch gekennzeichnet, dass** die Leck-Flussrate unter Berücksichtigung des Kühlfluidvolumens in der Fluidleitung zwischen der mindestens einen Komponente (5) und der Reaktionszeit der Regelvorrichtung so gewählt ist, dass bei einer plötzlichen Steigerung der Verlustleistung der mindestens einen Komponente (5) der Fluidstrom innerhalb einer ausreichend kurzen Zeitspanne so weit gesteigert wird, dass die mindestens eine Komponente (5) nicht geschädigt oder zerstört wird.

6. Fluid-Kühleinrichtung nach einem der vorhergehenden Ansprüche, **dadurch gekennzeichnet, dass** mehrere Verlustwärme erzeugende Komponenten (5) in Reihe hinsichtlich der Flussrichtung des Kühlfluids geschaltet sind.

7. Fluid-Kühleinrichtung nach einem der vorhergehenden Ansprüche, **dadurch gekennzeichnet, dass** das Kühlfluid auf mehrere parallele Zweige (I, II, III) aufgeteilt wird, wobei in jedem Zweig (I, II, III) mindestens eine Verlustwärme erzeugende Komponente (5) angeordnet ist, und dass in Flussrichtung des Kühlfluids am Ende jedes Zweigs (I, II, III) ein steuerbares Ventil oder ein Regelventil (11) enthalten ist.

8. Fluid-Regelventil für eine Fluid-Kühleinrichtung nach einem der vorhergehenden Ansprüche, **dadurch gekennzeichnet, dass** das Regelventil (11) eine "Geschlossen-Schaltstellung" aufweist, in welcher der Fluidstrom (f₁, f₂, f₃) nicht vollständig unterbrochen ist, sondern eine vorbestimmte Leck-Flussrate aufweist.

9. Fluid-Regelventil nach Anspruch 8, **dadurch gekennzeichnet, dass** ein Thermostatelement (21) vorgesehen ist, welches in thermischem Kontakt mit dem das Regelventil (11) durchströmenden Medium steht und einen Ventilkörper (37) beaufschlagt, wobei hierdurch der Ventilkörper (37), abhängig von der Temperatur des Mediums, zwischen einer "Geschlossen-Stellung", in welcher der Ventilkörper (37) vorzugsweise zumindest mit einem Teilbereich an einem Ventilsitz (39) anliegt, und einer "Offen-Stellung", in welcher der Ventilkörper vorzugsweise an einem die "Offen-Stellung" definierenden Anschlagselement (45) anliegt, bewegt wird.

10. Fluid-Regelventil nach Anspruch 8 oder 9, **dadurch gekennzeichnet, dass** der Ventilkörper an der der Beaufschlagungsseite durch das Thermostatelement (21) gegen-überliegenden Seite mittels einer Rückstellfeder (43) druckbeaufschlagt ist.

11. Fluid-Regelventil nach einem der Ansprüche 8 bis 10, **dadurch gekennzeichnet, dass** das Regelventil (11) ein hülsenartig ausgebildetes Ventilgehäuse (17) aufweist, in welchem das Thermostatelement (21), der Ventilsitz (39) und der Ventilkörper (37) und die Rückstellfeder (43) angeordnet sind, wobei das Ventilgehäuse (17) an seinen gegenüberliegenden Enden Anschlüsse für Leitungen aufweist, mittels welcher dem Regelventil (11) das Medium zuführbar und abführbar ist.

## Claims

1. Fluid cooling device for cooling at least one component which generates heat loss, in particular an electronic element,
a) in which the heat loss generated by the at least one component (5) is transmitted to a cooling fluid fed to the at least one component by means of a fluid conduit and
b) in which the cooling fluid in a fluid conduit is removed,
**characterised in that**
c) a regulating device is provided, comprising a controllable valve (11), arranged in the fluid conduit which removes the cooling fluid, by which the flow rate of the stream of fluid (f₁, f₂, f₃) of the cooling fluid is regulated independently of the temperature of the cooling fluid in the fluid conduit which removes the cooling fluid in such a way that the temperature of the cooling fluid maintains a preset desired temperature within preset limits.

2. Fluid cooling device according to claim 1, **characterised in that** the regulating device is constructed as a regulating valve (11), which preferably measures the temperature of the cooling fluid at the location of the regulating valve in the fluid conduit.

3. Fluid cooling device according to claim 2, **characterised in that** the regulating valve (11) is a passive thermostatic valve.

4. Fluid cooling device according to one of the preceding claims, **characterised in that** the controllable valve or the regulating valve (11) has a "closed position" in which the stream of fluid (f₁, f₂, f₃) is not completely interrupted, but has a predetermined leakage flow rate.

5. Fluid cooling device according to one of the preceding claims, **characterised in that** the leakage flow rate is chosen taking into consideration the volume of cooling fluid in the fluid conduit between the at least one component (5) and the reaction time of the regulating device in such a way that if there is a sudden increase in the power loss of the at least one component (5) the stream of fluid is increased within a sufficiently short period of time to such an extent that the at least one component (5) is not damaged or destroyed.

6. Fluid cooling device according to one of the preceding claims, **characterised in that** several components (5) which generate heat loss are switched in series in respect of the direction of flow of the cooling fluid.

7. Fluid cooling device according to one of the preceding claims, **characterised in that** the cooling fluid is divided over several parallel branches (I, II, III), wherein in each branch (I, II, III) at least one component (5) which generates heat loss is arranged, and **in that** a controllable valve or a regulating valve (11) is contained at the end of each branch (I, II, III) in the flow direction of the cooling fluid.

8. Fluid regulating valve for a fluid cooling device according to one of the preceding claims, **characterised in that** the regulating valve (11) has a "closed switching position" in which the stream of fluid (f₁, f₂, f₃) is not completely interrupted, but has a predetermined leakage flow rate.

9. Fluid regulating valve according to claim 8, **characterised in that** a thermostatic element (21) is provided, which is in thermal contact with the medium flowing through the regulating valve (11) and charges a valve body (37), wherein in this way, depending on the temperature of the medium, the valve body (37) is moved between a "closed position", in which the valve body (37) preferably rests with at least a partial area against a valve seat (39), and an "open position", in which the valve body preferably rests against a limit stop element (45) defining the "open position" .

10. Fluid regulating valve according to claim 8 or 9, **characterised in that** the valve body is pressure-charged by a restoring spring (43) on the side opposite the side charged by the thermostatic element (21).

11. Fluid regulating valve according to one of claims 8 to 10, **characterised in that** the regulating valve (11) has a valve housing (17) constructed like a sleeve, in which the thermostatic element (21), the valve seat (39) and the valve body (37) and the restoring spring (43) are arranged, the valve housing (17) having connections on its opposite ends for conduits by means of which the medium can be fed to and removed from the regulating valve (11).

## Revendications

1. Dispositif de refroidissement à fluide pour refroidir au moins un composant produisant de la chaleur par dissipation, en particulier un composant électronique,
a) dans lequel la chaleur dissipée, produite par au moins un composant (5), est transmise à un fluide de refroidissement amené au au moins un composant, au moyen d'une conduite à fluide,
b) dans lequel le fluide de refroidissement est évacué dans une conduite à fluide,
**caractérisé en ce qu'**
c) est prévu un dispositif de régulation, comprenant une soupape (11) pouvant être commandée, disposée dans la conduite à fluide évacuant le fluide de refroidissement, soupape à l'aide de laquelle le débit de l'écoulement de fluide (f1, f2, f3) du fluide de refroidissement est régulé en fonction de la température du fluide de refroidissement dans la conduite à fluide évacuant le fluide de refroidissement, **en ce que** la température du fluide de refroidissement respecte une température de consigne prédéterminée dans le cadre de limites prédéterminées.

2. Dispositif de refroidissement à fluide selon la revendication 1, **caractérisé en ce que** le dispositif de régulation est réalisé sous la forme d'une soupape de régulation (11), mesurant de préférence la température du fluide de refroidissement à l'emplacement de la soupape de régulation dans la conduite à fluide.

3. Dispositif de refroidissement à fluide selon la revendication 2, **caractérisé en ce que** la soupape de régulation (11) est une soupape thermostatique passive.

4. Dispositif de refroidissement à fluide selon l'une des revendications précédentes, **caractérisé en ce que** la soupape pouvant être commandée ou la soupape de régulation (11) présente une "position fermée" dans laquelle l'écoulement de fluide (f1, f2, f3) n'est pas complètement interrompu, mais présente un débit de fuite prédéterminé.

5. Dispositif de refroidissement à fluide selon l'une des revendications précédentes, **caractérisé en ce que** le débit de fuite est sélectionné en prenant en considération le volume de fluide de refroidissement dans la conduite à fluide, entre les au moins un composants (5) et le temps de réaction du dispositif de régulation, de manière que, en cas d'augmentation soudaine de la puissance des pertes des au moins un composants (5), le débit de fluide puisse être augmenté dans les limites d'un intervalle de temps suffisamment court, à un degré faisant que les au moins un composants (5) ne soient pas endommagés ni détruits.

6. Dispositif de refroidissement à fluide selon l'une des revendications précédentes, **caractérisé en ce que** plusieurs composants (5) produisant de la chaleur par perte sont branchés en série du point de vue du sens d'écoulement du fluide de refroidissement.

7. Dispositif de refroidissement à fluide selon l'une des revendications précédentes, **caractérisé en ce que** le fluide de refroidissement est réparti sur plusieurs ramifications (I, II, III) parallèles, dans chaque ramification (I, II, III) étant disposé au moins un composant (5) produisant de la chaleur par dissipation, et **en ce qu'**une soupape pouvant être commandée ou une soupape de régulation (11) est contenue à l'extrémité de chaque ramification (I, II, III), en observant dans la direction d'écoulement du fluide de refroidissement.

8. Soupape de régulation pour fluide, pour un dispositif de refroidissement à fluide selon l'une des revendications précédentes, **caractérisée en ce que** la soupape de régulation (11) présente une "position de commutation fermée", dans laquelle l'écoulement de fluide (f1, f2, f3) n'est pas complètement interrompu, mais présente un débit de fuite prédéterminé.

9. Soupape de régulation à fluide selon la revendication 8, **caractérisée en ce qu'**un élément thermostatique (21) est prévu, placé en contact thermique avec le fluide dont l'écoulement traverse la soupape de régulation (11) et sollicitant un corps de soupape (37), sachant que, de ce fait, en fonction de la température du fluide, le corps de soupape (37) est déplacé entre une "position fermée", dans laquelle le corps de soupape (37) est appliqué, de préférence au moins par une zone partielle, sur un siège de soupape (39), et une position "ouverte", dans laquelle le corps de soupape est appliqué, de préférence, sur un élément de butée (45) définissant la "position ouverte".

10. Soupape de régulation pour fluide selon la revendication 8 ou 9, **caractérisée en ce que** le corps de soupape est sollicité en pression au moyen d'un ressort de rappel (43) sur le côté opposé au côté de sollicitation par l'élément thermostatique (21).

11. Soupape de régulation de fluide selon l'une des revendications 8 à 10, **caractérisée en ce que** la soupape de régulation (11) présente un carter de soupape (17) en forme de douille, dans lequel l'élément statique (21), le siège de soupape (39) et le corps de soupape (37) et le ressort de rappel (43) sont disposés, le carter de soupape (17) présentant, à ses extrémités opposées, des raccordements pour des conduites, à l'aide desquelles le fluide peut être amené à et évacué de la soupape de régulation (11).
